# FASCICULE DE BREVET EUROPEEN

(11) **EP 3 991 256 B1**
(45) Date de publication et mention de la délivrance du brevet: **22.01.2025**
(21) Numéro de dépôt: 20747452.9
(22) Date de dépôt: 24.06.2020
(51) Int. Cl.: H02B 1/36, H02B 3/00

(54) **TIROIR DE MAINTENANCE POUR TABLEAU ÉLECTRIQUE DE DISTRIBUTION**
WARTUNGSEINSCHUB FÜR EINE ELEKTRISCHE VERTEILERTAFEL
MAINTENANCE DRAWER FOR AN ELECTRICAL DISTRIBUTION SWITCHBOARD

(30) Priorité: 26.06.2019 FR 1906977
(43) Date de publication de la demande: 04.05.2022
(73) Titulaire: Electricité de France, 75008 Paris (FR)
(72) Inventeur: BANET, Laurent, 69008 LYON (FR); GALASSO, Antoine, 69003 LYON (FR); RICHARD MOUNIER, Jean-Yves, 07350 CRUAS (FR)
(74) Mandataire: Regimbeau
(86) Numéro de dépôt international: PCT/FR2020/051105
(87) Numéro de publication internationale: WO 2020/260828

(56) Documents cités:
- WO-A1-2010/122765
- DE-A1- 102017 206 863
- DE-C1- 19 516 327
- US-A1- 2008 258 667

## Description

### Domaine technique

La présente invention se rapporte au domaine de la distribution électrique, et porte plus précisément sur un tiroir adapté pour être inséré dans un tableau électrique. Ce tiroir est spécialement conçu pour permettre à un opérateur de procéder à des opérations de maintenance ou de mesures en toute sécurité et de façon aisée.

### Arrière-plan technologique

De nombreux équipements électriques sont présents dans une installation industrielle. Ces équipements électriques, par exemple des moteurs, transformateurs, pompes ou autres machines, doivent faire l'objet d'opérations de surveillance et d'entretien régulières qui impliquent d'effectuer des mesures électriques, notamment pour en vérifier le bon fonctionnement.

Ces opérations sont par exemple menées directement sur l'équipement, préalablement mis hors tension et mis à la terre (en court-circuit) afin de protéger des risques électriques de l'opérateur intervenant sur l'équipement. La mise à la terre préalable se fait par exemple en connectant des pinces à chaque cosse d'une boîte à bornes de l'équipement. Une telle opération peut se révéler difficile à mettre en oeuvre, par exemple en raison d'un manque d'accessibilité des connexions électriques de l'équipement ou d'un manque de place, et exige que les outils utilisés telles que les pinces de connexion soient compatibles avec l'équipement. Tout défaut dans la réalisation de cette mise à la terre peut mettre en danger l'opérateur. Par ailleurs, il existe le risque qu'une personne, non informée de la maintenance ou par accident, remette l'équipement sous tension alors qu'un opérateur y travaille.

Les opérations de surveillance peuvent également être menées sur les bornes de raccordement électrique des câbles au niveau du tableau électrique, par exemple pour effectuer des mesures d'isolement ou de continuité électrique. Des outils de connexion, telles que des pinces, sont alors disposés sur les bornes sous tension, entraînant un risque majeur pour l'opérateur en cas de mauvaise manipulation. La solution consistant à mettre hors tension l'ensemble du tableau électrique présente l'inconvénient de mettre hors tension tous les équipements alimentés par ce tableau électrique, et ne peut donc être effectué par exemple uniquement lors d'arrêts programmés de maintenance, interdisant ainsi un suivi pourtant nécessaire. Cette solution sera donc évitée.

En outre, ces différentes opérations requièrent des manipulations mécaniques, comme par exemple le dévissage et le vissage de boulons de maintien des cosses de connexion, ou encore le démontage et le remontage de capots de protection, comme dans la demande de brevet WO2010/122765A1.

Sur le long terme, de telles manipulations augmentent sensiblement le risque de dégradation alors même que ces manipulations sont effectuées fréquemment dans un but de maintenance.

La demande de brevet US2008/258667A1 propose un système pour coordonner l'installation et le retrait d'une sous-unité de centre de commande moteur avec la connexion d'alimentation et l'interruption de celle-ci, avec un ensemble de verrouillage et d'indicateurs.

La demande de brevet DE102017206863A1 montre un tiroir de mesure comprenant des éléments de mesure et des contacts de masse.

Le brevet DE19516327C1 divulgue également un tiroir de mesure comprenant des contacts connectés à des prises de mesure par l'intermédiaire d'un interrupteur.

### Présentation de l'invention

L'invention a pour but de permettre à un opérateur de procéder à des opérations de maintenance ou de mesures en toute sécurité et de façon aisée sur un équipement électrique d'un site industriel.

A cet effet, il est proposé un tiroir comprenant :
- un châssis adapté pour permettre l'insertion du tiroir dans un emplacement d'un tableau de distribution,
- une façade avant fermant l'emplacement du tableau de distribution lorsque le tiroir est inséré dans un tableau de distribution,
- des bornes de connexion aval destinées à être reliées à une charge,
- une pluralité de connecteurs débouchant sur sa façade avant, chacun de ces connecteurs étant connecté à une borne de connexion aval et permettant la connexion d'un appareil de mesure,
dans lequel le tiroir présente un sélecteur actionnable depuis la façade avant, permettant de connecter et de déconnecter les bornes de connexion aval à une liaison équipotentielle, et définissant une position de mesure dans laquelle les bornes de connexion aval ne sont pas connectées à une liaison équipotentielle et une position de court-circuit dans laquelle les bornes de connexion aval sont connectées à la liaison équipotentielle.

Le tiroir selon l'invention permet de simplifier, accélérer et de sécuriser la réalisation de mesures et d'opérations de maintenance par un opérateur d'un site industriel. Le tiroir se monte provisoirement (le temps des mesures ou de l'intervention) à la place du tiroir d'alimentation résident dans le tableau électrique, et permet d'effectuer des mesures directement sur la façade du tiroir, de pouvoir travailler de façon isolée par rapport à l'alimentation amont provenant du tableau électrique. Le tiroir permet alors de sécuriser l'équipement en mettant les bornes de connexion en court-circuit et en liaison équipotentielle directement depuis la façade.

Le tiroir est avantageusement complété par les caractéristiques suivantes, prises seules ou en une quelconque de leur combinaison techniquement possible :
- le tiroir est dépourvu de bornes de connexion amont destinées à être reliées à une alimentation électrique du tableau électrique ;
- le tiroir présente une interface isolante destinée à faire face aux barres d'alimentation du tableau électrique ;
- le sélecteur est rotatif entre la position de mesure dans laquelle les bornes de connexion aval ne sont pas connectées à une liaison équipotentielle et la position de court-circuit dans laquelle les bornes de connexion aval sont connectées à la liaison équipotentielle ;
- le tiroir comprend en outre une poignée sur la façade avant, ladite poignée étant mobile entre une première position et une seconde position, la seconde position entraînant le blocage du tiroir dans le tableau de distribution lorsque le tiroir est inséré dans le tableau de distribution tandis que dans la première position le tiroir est libre de blocage dans le tableau de distribution afin de permettre son insertion ou son retrait, la poignée étant mécaniquement reliée au sélecteur de sorte qu'une rotation de la poignée entre la première position et la seconde position entraîne une rotation du sélecteur entre la position de mesure et la position de court-circuit, respectivement ;
- la poignée est munie d'un organe de verrouillage de la rotation de ladite poignée, configuré pour autoriser ou interdire la rotation de la poignée ;
- la poignée et le sélecteur sont rotatifs selon deux axes distincts, et la poignée est mécaniquement reliée au sélecteur par au moins une bielle ;
- le tiroir comprend un organe de court-circuitage électriquement conducteur reliable à une liaison équipotentielle, et le sélecteur comprend des organes de contact connectés à chaque borne de connexion aval et configurés pour venir, par rotation du sélecteur, au contact de l'organe de court-circuitage ;
- la façade comprend une partie principale mécaniquement liée au châssis, et une rallonge fixée sur un côté de façade de la partie principale.

L'invention concerne également un procédé de mesure de caractéristiques électriques d'une charge reliée aux bornes de connexion aval d'un tiroir selon l'invention, lorsque ledit tiroir est inséré dans un emplacement d'un tableau électrique, ledit procédé comprenant les étapes suivantes:
- positionnement du sélecteur dans la position de mesure,
- connexion d'un appareil de mesure à au moins deux connecteurs de la façade avant du tiroir,
- réalisation de mesures de caractéristiques électriques de la charge,
dans lequel les bornes de connexion aval comprennent des bornes de phase et une borne de masse, un connecteur de phase étant connecté à une borne de phase et un connecteur de masse étant relié à la borne de masse:
- la mesure est une vérification d'absence de tension, et l'appareil de mesure est un voltmètre, ou
- la mesure est une mesure de résistance d'isolement, les deux connecteurs sont un connecteur de phase et un connecteur de masse, et l'appareil de mesure est un contrôleur d'isolement configuré pour appliquer une tension entre les deux connecteurs et pour mesurer un courant circulant entre les deux connecteurs pour en déduire une résistance d'isolement, ou
- la mesure est une mesure de continuité électrique, les deux connecteurs sont deux connecteurs de phase, et l'appareil de mesure est un ampèremètre mesurant un courant circulant entre les deux connecteurs de phase, ou
- la mesure est une recherche de câble, l'appareil de mesure est configuré pour injecter dans les connecteurs au moins un signal de mesure présentant un motif particulier, et un détecteur est utilisé pour identifier des câbles de la charge dans lesquels transitent ledit signal de mesure.

L'invention concerne également un procédé d'une opération de maintenance d'un équipement relié aux bornes de connexion aval d'un tiroir selon l'invention lorsque ledit tiroir est inséré dans un emplacement d'un tableau électrique, ledit procédé comprenant les étapes suivantes:
- positionnement du sélecteur dans la position de court-circuit,
- connexion d'un appareil de mesure à au moins deux connecteurs de la façade avant du tiroir,
- vérification d'une absence de tension,
- réalisation de l'opération de maintenance de l'équipement.

Le procédé de mesure et/ou le procédé de maintenance peut comprendre une étape de verrouillage du positionnement du sélecteur en utilisant un organe de verrouillage de la rotation de la poignée mécaniquement reliée au sélecteur.

### Présentation des figures

L'invention sera mieux comprise, grâce à la description ci-après, qui se rapporte à un exemple de réalisation préféré, donné à titre d'exemple non limitatif et expliqué avec référence aux dessins schématiques annexés, parmi lesquels :
- la figure 1 est une vue d'ensemble en perspective de trois-quarts face et élévation d'un tiroir selon un mode de réalisation possible de l'invention ;
- la figure 2 est une vue latérale d'un tiroir selon un mode de réalisation possible de l'invention ;
- la figure 3 est une vue agrandie d'une partie de l'arrière de la façade avant d'un tiroir selon un mode de réalisation possible de l'invention ;
- la figure 4 est une vue agrandie d'une partie de l'arrière de la façade avant d'un tiroir selon un mode de réalisation possible de l'invention dans lequel la façade comprend plusieurs parties ;
- la figure 5 est une vue rapprochée de la section aval d'un tiroir selon un mode de réalisation possible de l'invention, montrant le sélecteur en position de connexion ;
- la figure 6 est une vue rapprochée de la section aval d'un tiroir selon un mode de réalisation possible de l'invention, montrant le sélecteur en position de sécurité.
- la figure 7 est une vue de trois-quarts face d'un tiroir selon un mode de réalisation possible de l'invention, montrant la poignée verrouillée horizontalement avec l'organe de blocage inactif ;
- la figure 8 est une vue de trois-quarts face d'un tiroir selon un mode de réalisation possible de l'invention, montrant la poignée verrouillée verticalement avec l'organe de blocage actif.

### Description détaillée

Un tableau électrique, également appelé tableau de distribution ou tableau de répartition, est un ensemble comportant différents types d'appareillage associés à un ou plusieurs circuits électriques de d'arrivée, ou charges, alimentés par un ou plusieurs circuits électriques d'alimentation, ainsi que des bornes pour le conducteur neutre et le conducteur de protection. Dans les applications industrielles, un tableau électrique peut prendre la forme d'une armoire accueillant des tiroirs d'alimentation qui sont insérés dans l'armoire à des emplacements dédiés.

Un tiroir d'alimentation conventionnel comprend une façade avant fermant le tableau de distribution, un châssis métallique présentant un rail pour l'insertion et le retrait du tiroir d'alimentation, une partie amont comprenant des bornes de connexion amont vers l'alimentation électrique, et une partie aval comprenant des bornes de connexion aval vers la charge. Le tiroir d'alimentation accueille également des composants électriques tels que des relais, des contacteurs ou des fusibles, aussi bien dans sa partie aval que dans sa partie amont.

L'invention propose un tiroir configuré pour remplacer un tiroir d'alimentation conventionnel dans un tableau de distribution afin de pouvoir effectuer des mesures ou des opérations de maintenance sur un équipement relié à ce tableau de distribution.

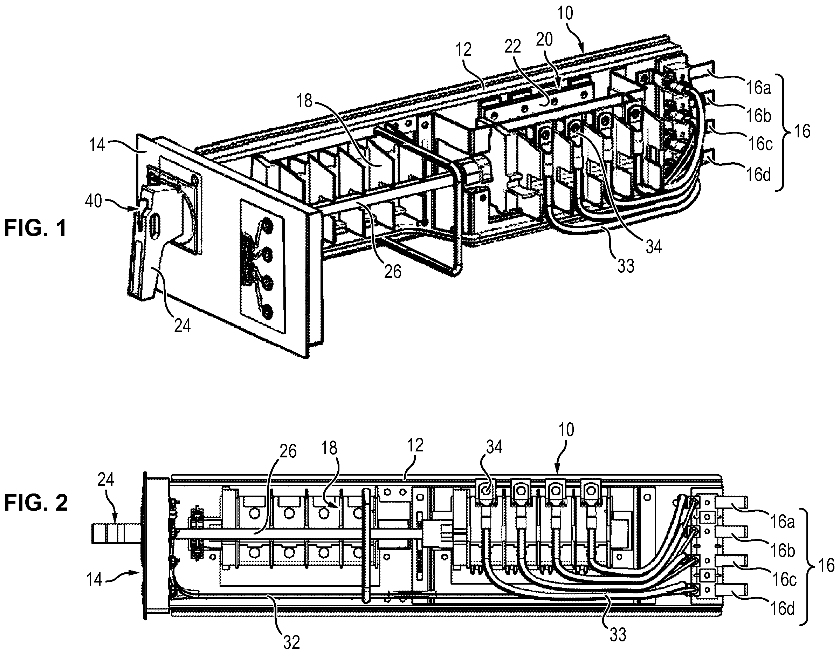

En référence aux **figures 1 et 2****,** un tiroir selon un mode de réalisation possible, décrit à titre d'exemple illustratif, comprend un châssis 10 adapté pour permettre l'insertion du tiroir dans un emplacement d'un tableau de distribution. Le châssis 10 est par exemple en acier. Le châssis 10 s'insère dans des glissières de l'emplacement du tableau de distribution. Le châssis 10 peut comprendre un rail 12 afin de guider l'insertion ou le retrait du tiroir de l'emplacement du tableau électrique. Le châssis 10 sert de support aux autres composants du tiroir.
Le tiroir comprend une façade 14 avant fermant l'emplacement du tableau de distribution lorsque le tiroir est inséré dans un tableau de distribution. La taille et la forme du tiroir reprend la forme et la taille du tiroir d'alimentation conventionnel qu'il remplace dans le tableau électrique. De préférence toutefois, la façade 14 avant présente une couleur distincte de celle des tiroirs d'alimentation conventionnel afin d'être facilement identifiable. Par exemple, la façade 14 peut être de couleur verte ou rouge lorsque les tiroirs d'alimentation sont bleus. Par ailleurs, la façade 14 peut être pourvue d'une périphérie qui conserve l'indice de protection (ou "IP") du tableau de distribution électrique lorsque le tiroir d'alimentation conventionnel est en place. L'indice de protection du tableau est tel que défini dans la norme internationale CEI 60529. Il peut s'agir par exemple, et non limitativement, d'un « Indice de Protection 31 » ; le nombre '31' se décomposant en deux chiffres ; le premier chiffre '3' se rapportant au degré de protection contre la pénétration des corps étrangers solides de dimension supérieure à 12 nm, le second chiffre '1' se rapportant au degré de protection contre la pénétration de l'eau sous forme de chutes de gouttes d'eau.

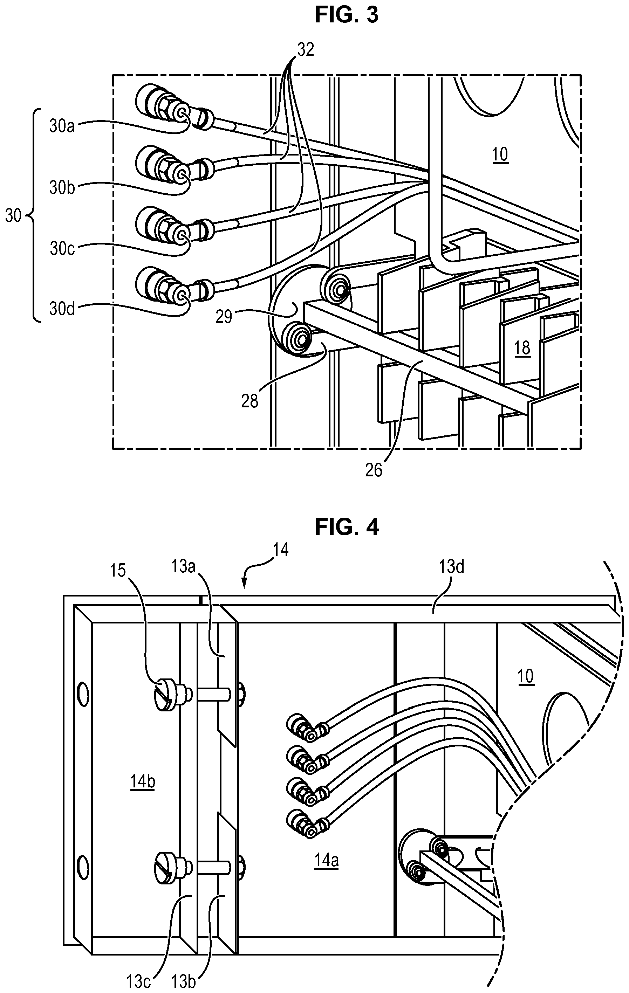

Afin de permettre de conserver une étanchéité similaire à celle du tiroir d'alimentation conventionnel qu'il remplace, la façade 14 avant du tiroir doit obturer l'ouverture de l'emplacement du tableau de distribution lorsque le tiroir est inséré dans le tableau de distribution. Il faut donc que les dimensions de la façade 14 correspondent aux dimensions de cette ouverture. Or, les ouvertures d'emplacements du tableau de distribution peuvent présenter différentes dimensions. Plutôt que de prévoir des tiroirs avec autant de tailles de façade 14 que de tailles d'ouvertures d'emplacements du tableau de distribution, la façade 14 du tiroir peut être composée de plusieurs parties distinctes solidarisées par des organes de fixation.
En référence à la figure 4, la façade 14 peut ainsi comprendre une partie principale 14a mécaniquement liée au châssis 10, et une rallonge 14b fixée sur un côté de façade de la partie principale 14a. C'est sur cette partie principale 14a que débouche la pluralité de connecteurs connectés chacun à une borne de connexion aval et le sélecteur, qui seront discuté plus bas.

La rallonge 14b est fixée sur la partie principale 14a par des organes de fixation 15, qui sont ici des boulons. A cet effet, la partie principale 14a et la rallonge 14b peuvent présenter des trous configurés pour se faire face après assemblage de la rallonge 14b sur la partie principale 14a, pour permettre le passage des organes de fixation 15. La partie principale 14a et la rallonge 14b peuvent présenter des brides 13a, 13b se faisant face dans lesquelles sont ménagés lesdits trous. Une bride supplémentaire 13c peut être prévue sur la face interne de la rallonge 14b, à distance de la bride 13b de la rallonge 14b, et pourvue de trous permettant le passage des organes de fixation 15, pour le maintien desdits organes de fixation 15. D'autres solutions peuvent être envisagées pour solidariser les parties de la façade 14. La rallonge 14b pourrait être glissante par rapport à la partie principale 14a, avec un blocage du glissement. Grâce à la rallonge, il est possible, à partir d'un tiroir pourvue d'une façade 14 présentant les dimensions les plus courantes (i.e. celles de la partie principale 14a), de modifier cette façade 14 avec la rallonge 14b pour l'adapter à des emplacements avec des ouvertures de dimensions plus grandes, de manière simple et moins coûteuse que d'être contraint de prévoir des tiroirs spécifiquement dédiés à certaines dimensions particulières.

Par ailleurs, afin de conserver l'indice de protection, le tiroir peut être configuré pour fermer de manière étanche l'ouverture de l'emplacement du tableau de distribution, en coopérant avec un élément d'étanchéité tel qu'un joint. L'élément d'étanchéité peut être présent sur la périphérie de l'ouverture de l'emplacement du tableau de distribution, et la façade 14 du tiroir peut alors comprendre, typiquement sur la périphérie de sa face interne, un espace de réception de cet élément d'étanchéité. Cet espace de réception peut par exemple être défini par une bride 13d périphérique sur la face interne de la façade 14 faisant saillie vers l'intérieur du tiroir à distance du bord de face interne de la façade 14, dégageant l'espace de réception pour l'élément d'étanchéité qui sera alors comprimé entre la périphérie de la face interne de la façade 14 et la bride 13d. Il est à noter que cette bride 13d peut faire fonction de bride 13a permettant la fixation de la rallonge 14b.

Le tiroir comprend également des bornes de connexion aval 16 destinées à être reliées à une charge. Typiquement, et comme dans l'exemple illustré, les bornes de connexion aval 16 prennent la forme de couteaux, c'est-à-dire de broches plates, destinées à être insérées dans des réceptacles d'un bornier de raccordement du tableau électrique pour être électriquement connectées, via une liaison électrique de type câble, à un équipement formant une charge électrique, comme par exemple un moteur ou un transformateur. Il y a une borne de connexion aval 16 par phase de la connexion électrique, et une borne de connexion aval 16 pour la masse, également appelée terre ou liaison équipotentielle. Typiquement, une installation industrielle utilise une alimentation électrique avec trois phases, d'où la présence de quatre bornes de connexion 16 sur l'exemple illustré, avec une borne de masse 16a, et trois bornes de connexion de phase 16b, 16c, 16d.

Contrairement à un tiroir d'alimentation conventionnel, le tiroir est dépourvu de bornes de connexion amont destinées à être reliées à une alimentation électrique du tableau électrique. A la place, le tiroir présente une interface 18 isolante destinée à faire face aux barres d'alimentation du tableau électrique, afin d'isoler le tiroir des barres d'alimentation, ce qui permet de s'assurer de l'absence d'alimentation électriques des bornes de connexion aval 16.

Le tiroir comporte en outre un sélecteur 20 actionnable depuis la façade 14 et permettant de connecter et de déconnecter les bornes de connexion aval 16 à une liaison équipotentielle. Le sélecteur 20 est un organe mécanique permettant de sélectionner un mode de fonctionnement ou un autre mode de fonctionnement du tiroir en opérant une modification de la configuration du tiroir. Le sélecteur 20 peut par exemple être un interrupteur ou un sectionneur.

Plus précisément, le tiroir comprend un organe de court-circuitage 22 électriquement conducteur relié à une liaison équipotentielle, et le sélecteur 20 est rotatif entre une position de mesure dans laquelle les bornes de connexion aval 16 ne sont pas connectées à la liaison équipotentielle et une position de court-circuit dans laquelle les bornes de connexion aval 16 sont connectées, via l'organe de court-circuitage 22, à la liaison équipotentielle.

Pour ce faire, le tiroir comprend une poignée 24 sur la façade 14, mobile en rotation entre au moins une première position et une seconde position. La poignée 24 est située sur la face de la façade 14 opposée au châssis 10, de sorte que la poignée 24 est accessible de l'extérieur du tableau électrique lorsque le tiroir est inséré dans le tableau de distribution. Sur la **figure 1****,** la poignée 24 est dans une première position verticale, tandis que sur la **figure 2****,** la poignée 24 est dans une seconde position verticale. Il est bien sûr possible de prévoir plus de deux positions pour la poignée 24.

Le sélecteur 20 peut comprendre une tige 26 s'étendant depuis la façade 14 jusqu'à des organes de contact du tiroir, connectés à chaque borne de connexion 16 et configurés pour venir, par rotation du sélecteur 20, au contact de l'organe de court-circuitage 22. Plus précisément, la rotation de la poignée 24 entraîne la rotation de la tige 26, qui entraîne la rotation des organes de contact. Comme représenté sur la **figure 3**, il est possible que la poignée 24 et le sélecteur 20 (ou plus précisément la tige 26) ne soient pas alignés, et soient par conséquent rotatifs selon deux axes distincts. La poignée 24 peut alors être mécaniquement reliée au sélecteur 20 par au moins une bielle 28. Dans l'exemple, la partie de la poignée 24 traversant la façade 14 est reliée à deux bielles 28 s'étendant le long de la face intérieure de la façade 14. Ces bielles 28 sont reliées à une pièce 29 de façon excentrée par rapport à un axe atour duquel tourne cette pièce 29, la tige 26 étant solidaire de cette pièce 29 rotative.

Le tiroir de distribution présente une pluralité de connecteurs 30 débouchant sur sa façade avant, chacun de ces connecteurs 30 étant connecté à une borne de connexion aval 16. Il y a ainsi un connecteur de masse 30a connecté à la borne de masse 16a, et trois connecteurs de phase 30b, 30c, 30d reliés à chacun à une borne de phase 16b, 16c, 16d. Les connecteurs 30 traversent la façade 14 de sorte que les connecteurs 30 sont accessibles de l'extérieur du tableau électrique lorsque le tiroir est inséré dans le tableau de distribution, tout en étant connectés aux bornes de connexion 16 à l'intérieur. Les connecteurs 30 permettent la connexion d'un appareil de mesure. Les connecteurs sont des connecteurs femelles, par exemple du type 4 mm, et peuvent par exemple des douilles de sécurité isolées couramment désignés sous terme de connecteur banane pouvant accueillir des fiches banane mâle. De façon simple, la connexion entre les connecteurs 30 est la borne de connexion aval 16 peut être réalisée par des fils 32 reliant directement chaque connecteur 30 à sa borne de connexion 16, comme sur l'exemple illustré. Il est également possible de prévoir des fils reliant chaque connecteur 30 à un élément conducteur tel que les cosses 34 connecté à sa borne de connexion 16.

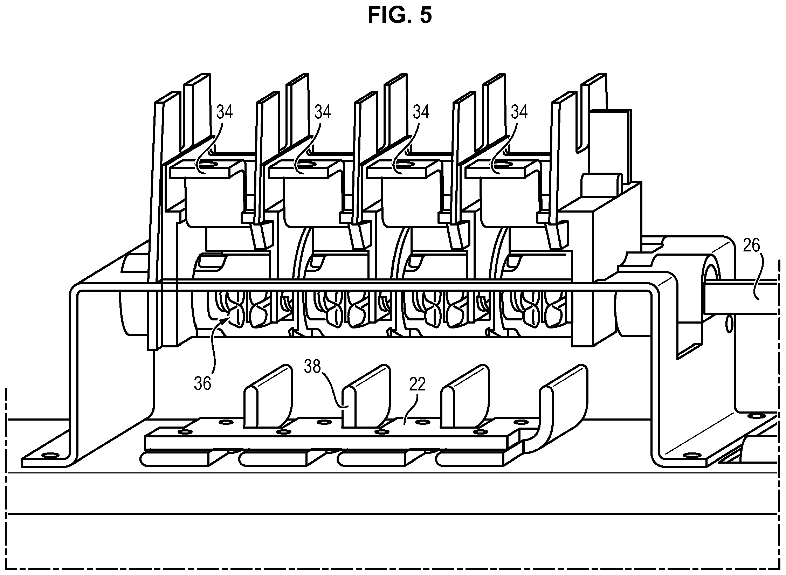

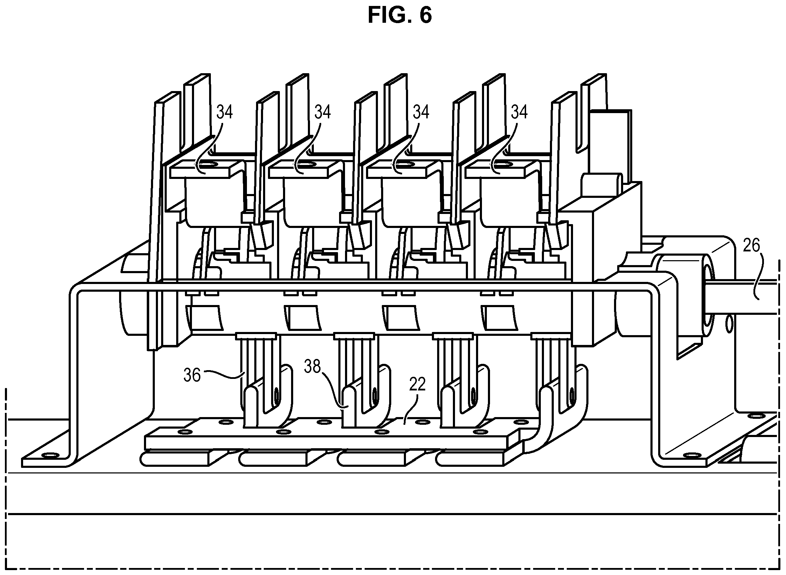

Dans les **figures 5** et **6****,** les fils 32 reliant directement chaque connecteur 30 à sa borne de connexion 16 et les fils 33 reliant les bornes de connexion 16 à des cosses 34 électriquement connectées au sélecteur 20 ne sont pas représentées à des fins de clarification. Les cosses 34 sont électriquement connectées aux organes de contact 36 du sélecteur 20 qui sont rotatifs. Sur la **figure 5****,** le sélecteur 20 est en position de mesure, qui correspond par exemple à la première position de la poignée 24, c'est-à-dire en position horizontale sur les exemples illustrés. Les organes de contact 36 du sélecteur 20 sont relevés, et ne sont pas en contact avec l'organe de l'organe de court-circuitage 22. Les bornes de connexion aval 16 ne sont pas connectées à la liaison équipotentielle.

Dans cette position, les bornes de connexion aval 16 ne sont pas en court-circuit. Il est donc possible de procéder à une mesure de caractéristiques électriques de l'équipement (moteur ou transformateur par exemple) relié aux bornes de connexion aval 16 du tiroir constituant la charge. Il suffit de connecter un appareil de mesure à au moins deux connecteurs 30 de la façade avant 14 du tiroir, pour réaliser des mesures. Par exemple, la mesure peut être une vérification d'absence de tension, et l'appareil de mesure est un voltmètre, branché alors sur le connecteur de masse 30a et successivement sur les différents connecteurs de phase 30b, 30c, 30d.

La mesure peut également être une mesure de résistance d'isolement. Les deux connecteurs sur lequel sont branchés l'appareil de mesure sont un connecteur de phase 30b, 30c, 30d et le connecteur de masse 30a. L'appareil de mesure est un contrôleur d'isolement configuré pour appliquer une tension entre les deux connecteurs 30 et pour mesurer un courant circulant entre les deux connecteurs 30 pour en déduire une résistance d'isolement.

La mesure peut également être une mesure de continuité électrique, les deux connecteurs sont deux connecteurs de phase 30b, 30c, 30d, et l'appareil de mesure est un ampèremètre mesurant un courant circulant entre les deux connecteurs de phase 30b, 30c, 30d.

La mesure peut être aussi une recherche de câble, l'appareil de mesure est alors configuré pour injecter dans les connecteurs 30, au moins un signal de mesure présentant un motif particulier. Un détecteur est alors utilisé pour identifier des câbles de la charge dans lesquels transitent ledit signal de mesure. Le motif injecté peut correspondre à un signal variable en tension ou en intensité, susceptible de générer un signal électromagnétique au voisinage des câbles concernés dans lesquels transitent ledit signal de mesure, et le détecteur peut à distance détecter ce signal électromagnétique.

Sur la **figure 6****,** suite au pivotement de la poignée 24 dans sa seconde position, la rotation de la tige 26 a entraîné la rotation des organes de contact 36 du sélecteur 20, qui en pivotant sont venus au contact de l'organe de court-circuitage 22. Le sélecteur 20 est alors positionné dans une position de court-circuit.

Par exemple, l'organe de court-circuitage 22 peut présenter des parties saillantes 38 (une par phase et pour la masse) et les organes de contact 36 peuvent présenter une forme de U dont les branches viennent se placer de chaque côté des parties saillantes 38, de sorte à enserrer ces parties saillantes 38 pour réaliser un contact électrique entre l'organe de court-circuitage 22 et les organes de contact 36 du sélecteur 20 qui sont en connexion électriques avec les bornes de connexion 16. Les parties saillantes 38 de l'organe de court-circuitage 22 sont électriquement reliées entre elles, et les bornes de connexion aval 16 sont donc en court-circuit entre elles. Du fait que la borne de masse 16a est désormais connectée aux trois bornes de connexion de phase 16b, 16c, 16d, les bornes de connexion aval 16 sont alors connectées à la masse, c'est-à-dire à une liaison équipotentielle. De préférence, l'organe de court-circuitage 22 est également lié à la masse, par exemple par son contact avec le châssis 10. L'organe de court-circuitage 22, y compris ses parties saillantes 38, est réalisé dans un matériau électriquement conducteur.

Une fois que les bornes de connexion aval 16 sont liées à une liaison équipotentielle et en court-circuit, il est possible à un opérateur d'effectuer une opération de maintenance d'un équipement relié aux bornes de connexion aval 16 du tiroir en toute sécurité. L'opérateur peut vérifier une absence de tension en connectant un appareil de mesure tel qu'un voltmètre à au moins deux connecteurs 30 de la façade avant 14 du tiroir, puis réaliser l'opération de maintenance sur l'équipement.

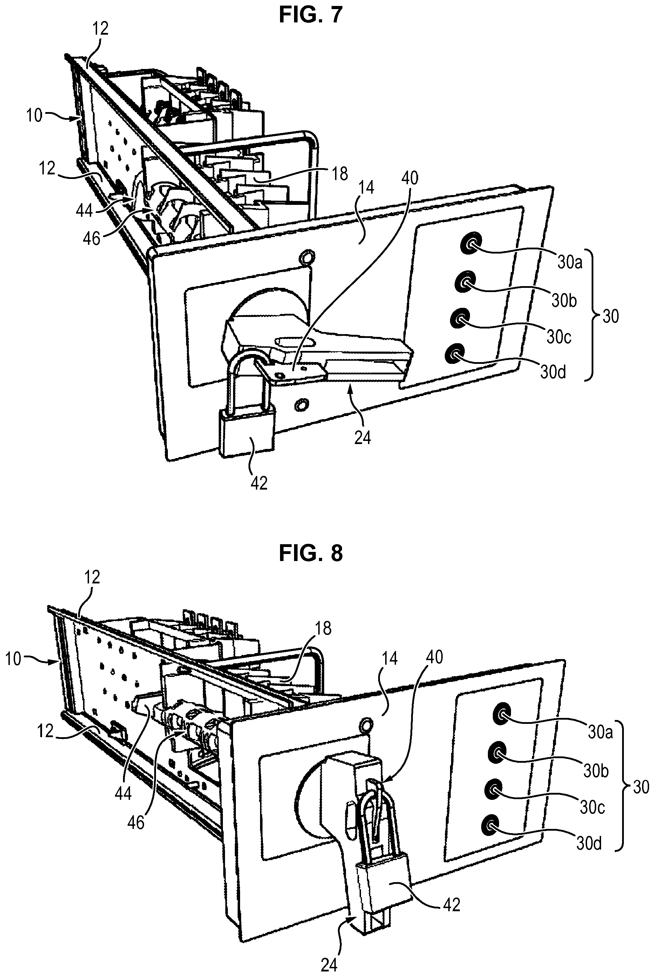

Il est préférable que le tiroir ne puisse pas subir de modification de son état par accident pendant des mesures ou des opérations de maintenance. Il est donc possible de verrouiller le positionnement du sélecteur 20 en utilisant un organe de verrouillage 40 de la rotation de la poignée 24 mécaniquement reliée au sélecteur 20, comme illustré sur les **figures 7** et **8****.** L'organe de verrouillage peut prendre la forme d'une languette métallique 40, dont l'enfoncement est nécessaire pour autoriser la rotation de la poignée 24. Cette languette métallique 40 lorsqu'elle fait saillie de la poignée 24 présente un ou plusieurs trous permettant d'y introduire un ou plusieurs cadenas 42 respectivement, interdisant l'enfoncement de la languette 40 et donc la rotation de la poignée 24.

Par ailleurs, pour assurer la sécurité de l'opérateur, le tiroir est blocable dans le tableau de distribution, afin d'interdire tout retrait accidentel. Ce blocage s'effectue au moyen de la poignée 24. Comme évoqué, la poignée 24 est mobile entre une première position et une seconde position, la seconde position entraînant le blocage du tiroir dans le tableau de distribution lorsque le tiroir est inséré dans le tableau de distribution tandis que dans la première position le tiroir est libre de blocage dans le tableau de distribution afin de permettre son insertion ou son retrait. Pour ce faire, le tiroir comprend au moins un organe de blocage du tiroir dans le tableau de distribution, actionnable par la poignée 24.

La **figure 7** montre ainsi un exemple de tiroir avec la poignée 24 dans la première position, ici la position horizontale, verrouillée par un cadenas 42 passé dans le trou de la languette 40. L'organe de blocage comprend au moins un bras de blocage 44 solidaire de la rotation de la poignée 24, laquelle se prolonge le long du châssis 10 par un arbre sur lequel est monté le bras de blocage 44. Sur la **figure 7****,** le bras de blocage 44 est relevé, ne s'étendant pas au-delà des rails 12, et permettant d'insérer le tiroir. De même, des doigts 46 sont montés sur l'arbre et sont relevés.

La **figure 8** montre un exemple de tiroir avec la poignée 24 dans la seconde position, ici la position verticale, verrouillée par un cadenas 42 passé dans le trou de la languette 40. Le bras de blocage 44, qui a pivoté avec la poignée, fait désormais saillie au-delà du plan défini entre les deux rails 12, et par coopération avec le bâti du tableau électrique, s'oppose au retrait du tiroir. Les doigts 46 ont également pivoté, et s'engagent alors avec les barres d'alimentation électrique du tableau (non représentées). Les doigts 46, et de préférence le bras de blocage 44 sont en matériau isolant tel que du plastique, permettant d'isoler électriquement le tiroir des barres d'alimentation en même temps que de rigidifier le maintien du tiroir dans son emplacement. De même, l'interface 18 est isolante et isole encore le tiroir des barres d'alimentation, ce qui permet de s'assurer de l'absence d'alimentation électriques des bornes de connexion aval 16. En outre, l'ensemble 18 peut former un guide pour la tige 26.

L'invention n est pas limitée au mode de réalisation décrit et représenté aux figures annexées. Des modifications restent possibles, notamment du point de vue de la constitution des divers éléments ou par substitution d'équivalents techniques, sans sortir pour autant du domaine de protection de l'invention, qui est défini dans les revendications.

## Revendications

1. Tiroir comprenant :
- un châssis (10) adapté pour permettre l'insertion du tiroir dans un emplacement d'un tableau de distribution,
- une façade avant (14) fermant l'emplacement du tableau de distribution lorsque le tiroir est inséré dans un tableau de distribution,
- des bornes de connexion aval (16) destinées à être reliées à une charge,
- une pluralité de connecteurs (30) débouchant sur sa façade avant (14), chacun de ces connecteurs étant connecté à une borne de connexion aval (16) et permettant la connexion d'un appareil de mesure,
où le tiroir présente un sélecteur (20) actionnable depuis la façade avant (14),
**caractérisé en ce que** le sélecteur permet de connecter et de déconnecter les bornes de connexion aval (16) à une liaison équipotentielle et définit une position de mesure dans laquelle les bornes de connexion aval (16) ne sont pas connectées à une liaison équipotentielle et une position de court-circuit dans laquelle les bornes de connexion aval (16) sont connectées à la liaison équipotentielle.

2. Tiroir selon la revendication 1, dans lequel le tiroir est dépourvu de bornes de connexion amont destinées à être reliées à une alimentation électrique du tableau électrique.

3. Tiroir selon la revendication 2, présentant une interface isolante (18) destinée à faire face aux barres d'alimentation du tableau électrique.

4. Tiroir selon l'une quelconque des revendications précédentes, dans lequel le sélecteur (20) est rotatif entre la position de mesure dans laquelle les bornes de connexion aval (16) ne sont pas connectées à une liaison équipotentielle et la position de court-circuit dans laquelle les bornes de connexion aval (16) sont connectées à la liaison équipotentielle.

5. Tiroir selon la revendication précédente, comprenant en outre une poignée (24) sur la façade avant (14), ladite poignée étant mobile entre une première position et une seconde position, la seconde position entraînant le blocage du tiroir dans le tableau de distribution lorsque le tiroir est inséré dans le tableau de distribution tandis que dans la première position le tiroir est libre de blocage dans le tableau de distribution afin de permettre son insertion ou son retrait, la poignée (24) étant mécaniquement reliée au sélecteur de sorte qu'une rotation de la poignée (24) entre la première position et la seconde position entraîne une rotation du sélecteur (20) entre la position de mesure et la position de court-circuit, respectivement.

6. Tiroir selon la revendication précédente, dans lequel la poignée (24) est munie d'un organe de verrouillage (40) de la rotation de ladite poignée (24) configuré pour autoriser ou interdire la rotation de la poignée (24).

7. Tiroir selon l'une quelconque des revendications 1 à 6, dans lequel la poignée (24) et le sélecteur (20) sont rotatifs selon deux axes distincts, et la poignée (24) est mécaniquement reliée au sélecteur (20) par au moins une bielle (28).

8. Tiroir selon l'une quelconque des revendications 1 à 6, dans lequel le tiroir comprend un organe de court-circuitage (22) électriquement conducteur reliable à une liaison équipotentielle, et le sélecteur (20) comprend des organes de contact (36) connectés à chaque borne de connexion aval (16) et configurés pour venir, par rotation du sélecteur (20), au contact de l'organe de court-circuitage (22).

9. Tiroir selon l'une quelconque des revendications précédentes, dans lequel la façade (14) comprend une partie principale (14a) mécaniquement liée au châssis (10), et une rallonge (14b) fixée sur un côté de façade de la partie principale (14a).

10. Procédé de mesure de caractéristiques électriques d'une charge reliée aux bornes de connexion aval (16) d'un tiroir selon l'une quelconque des revendications 1 à 9, lorsque ledit tiroir est inséré dans un emplacement d'un tableau électrique, ledit procédé comprenant les étapes suivantes:
- positionnement du sélecteur (20) dans la position de mesure,
- connexion d'un appareil de mesure à au moins deux connecteurs (30) de la façade avant (14) du tiroir,
- réalisation de mesures de caractéristiques électriques de la charge,
dans lequel les bornes de connexion aval (16) comprennent des bornes de phase (16b, 16c, 16d) et une borne de masse (16a), un connecteur de phase (30b, 30c, 30d) étant connecté à une borne de phase (16b, 16c, 16d) et un connecteur de masse (30a) étant relié à la borne de masse (16a):
- la mesure est une vérification d'absence de tension, et l'appareil de mesure est un voltmètre, ou
- la mesure est une mesure de résistance d'isolement, les deux connecteurs sont un connecteur de phase (30b, 30c, 30d) et un connecteur de masse (30a), et l'appareil de mesure est un contrôleur d'isolement configuré pour appliquer une tension entre les deux connecteurs et pour mesurer un courant circulant entre les deux connecteurs pour en déduire une résistance d'isolement, ou
- la mesure est une mesure de continuité électrique, les deux connecteurs sont deux connecteurs de phase (30b, 30c, 30d), et l'appareil de mesure est un ampèremètre mesurant un courant circulant entre les deux connecteurs de phase (30b, 30c, 30d), ou
- la mesure est une recherche de câble, l'appareil de mesure est configuré pour injecter dans les connecteurs (30) au moins un signal de mesure présentant un motif particulier, et un détecteur est utilisé pour identifier des câbles de la charge dans lesquels transitent ledit signal de mesure.

11. Procédé d'une opération de maintenance d'un équipement relié aux bornes de connexion aval (16) d'un tiroir selon l'une quelconque des revendications 1 à 9 lorsque ledit tiroir est inséré dans un emplacement d'un tableau électrique, ledit procédé comprenant les étapes suivantes:
- positionnement du sélecteur (20) dans la position de court-circuit,
- connexion d'un appareil de mesure à au moins deux connecteurs (30) de la façade avant (14) du tiroir,
- vérification d'une absence de tension,
- réalisation de l'opération de maintenance de l'équipement.

12. Procédé selon l'une quelconque des revendications 10 ou 11, comprenant une étape de verrouillage du positionnement du sélecteur (20) en utilisant un organe de verrouillage (40) de la rotation de la poignée (24) mécaniquement reliée au sélecteur (20).

## Patentansprüche

1. Schublade, umfassend :
- Einem Rahmen (10), der so beschaffen ist, dass er das Einsetzen der Schublade in einen Steckplatz einer Schalttafel ermöglicht,
- eine Vorderfront (14), die den Steckplatz der Schalttafel verschließt, wenn der Schublade in eine Schalttafel eingeschoben wird,
- nachgeschaltete Anschlussklemmen (16), die dazu bestimmt sind, mit einer Last verbunden zu werden,
- eine Vielzahl von Steckverbindern (30), die in seine Vorderfront (14) münden, wobei jeder dieser Steckverbinder mit einer nachgeschalteten Anschlussklemme (16) verbunden ist und den Anschluss eines Messgeräts ermöglicht,
wobei die Schublade einen Wähler (20) aufweist, der von der Vorderfront (14) aus betätigt werden kann, **dadurch gekennzeichnet, dass** der Wähler das Verbinden und Trennen den nachgeschalteten Anschlussklemmen (16) mit einem Potentialausgleich ermöglicht und eine Messposition, in der die nachgeschalteten Anschlussklemmen (16) nicht mit einem Potentialausgleich verbunden sind, und eine Kurzschlussposition, in der die nachgeschalteten Anschlussklemmen (16) mit dem Potentialausgleich verbunden sind, definiert.

2. Schublade nach Anspruch 1, wobei die Schublade keine zugeschalteten Anschlussklemmen aufweist, die dazu bestimmt sind, mit einer Stromversorgung der Schalttafel verbunden zu werden.

3. Schublade nach Anspruch 2, die eine isolierende Schnittstelle (18) aufweist, die dazu bestimmt ist, den Stromschienen der elektrischen Schalttafel gegenüber zu liegen.

4. Schublade nach einem der vorhergehenden Ansprüche, wobei der Wähler (20) zwischen der Messposition, in der die nachgeschalteten Anschlussklemmen (16) nicht mit einem Potenzialausgleich verbunden sind, und der Kurzschlussposition, in der die nachgeschalteten Anschlussklemmen (16) mit dem Potenzialausgleich verbunden sind, drehbar ist.

5. Schublade nach dem vorhergehenden Anspruch, die außerdem einen Griff (24) an der Vorderfront (14) umfasst, wobei der Griff zwischen einer ersten Position und einer zweiten Position beweglich ist, wobei die zweite Position die Blockierung der Schublade in der Schalttafel bewirkt, wenn die Schublade in die Schalttafel eingeschoben wird, während die Schublade in der ersten Position frei von der Blockierung in der Schalttafel ist, um das Einsetzen oder Herausnehmen der Schublade zu ermöglichen, wobei der Griff (24) mechanisch mit dem Wähler verbunden ist, so dass eine Drehung des Griffs (24) zwischen der ersten Position und der zweiten Position eine Drehung des Wählers (20) zwischen der Messposition bzw. der Kurzschlussposition bewirkt.

6. Schublade nach dem vorhergehenden Anspruch, wobei der Griff (24) mit einem Sperrorgan (40) für die Drehung des Griffs (24) versehen ist, das so konfiguriert ist, dass es die Drehung des Griffs (24) zulässt oder unterbindet.

7. Schublade nach einem der Ansprüche 1 bis 6, wobei der Griff (24) und der Wähler (20) um zwei unterschiedliche Achsen drehbar sind und der Griff (24) über mindestens eine Pleuelstange (28) mechanisch mit dem Wähler (20) verbunden ist.

8. Schublade nach einem der Ansprüche 1 bis 6, wobei die Schublade ein elektrisch leitendes Kurzschlussorgan (22) umfasst, das mit einem Potentialausgleich verbindbar ist, und der Wähler (20) Kontaktorgane (36) umfasst, die mit jeder nachgeschalteten Anschlussklemme (16) verbunden und so konfiguriert sind, dass sie durch Drehung des Wählers (20) mit dem Kurzschlussorgan (22) in Kontakt kommen.

9. Schublade nach einem der vorhergehenden Ansprüche, wobei die Vorderfront (14) einen Hauptteil (14a), der mechanisch mit dem Rahmen (10) verbunden ist, und eine Verlängerung (14b) umfasst, die an einer Frontseite des Hauptteils (14a) befestigt ist.

10. Verfahren zum Messen der elektrischen Eigenschaften einer Last, die mit den nachgeschalteten Anschlussklemmen (16) einer Schublade nach einem der Ansprüche 1 bis 9 verbunden ist, wenn der Einschub in einen Steckplatz einer elektrischen Schalttafel eingesetzt ist, wobei das Verfahren die folgenden Schritte umfasst:
- Positionieren des Wählers (20) in der Messposition,
- Anschließen eines Messgeräts an mindestens zwei Steckverbindern (30) an der Vorderfront (14) der Schublade,
- Durchführung von Messungen der elektrischen Eigenschaften der Last,
wobei die nachgeschalteten Anschlussklemmen (16) Phasenanschlussklemmen (16b, 16c, 16d) und einen Erdungsanschlussklemme (16a) umfassen, wobei ein Phasenverbinder (30b, 30c, 30d) mit einer Phasenanschlussklemme (16b, 16c, 16d) verbunden ist und ein Erdungsverbinder (30a) mit der Erdungsanschlussklemme (16a) verbunden ist:
- die Messung eine Prüfung auf Spannungsfreiheit ist und das Messgerät ein Voltmeter ist, oder
- die Messung eine Isolationswiderstandsmessung ist, die beiden Steckverbinder ein Phasenverbinder (30b, 30c, 30d) und ein Erdungsverbinder (30a) sind und das Messgerät ein Isolationsprüfer ist, der so konfiguriert ist, dass er eine Spannung zwischen den beiden Steckverbinder anlegt und einen zwischen den beiden Anschlussklemmen fließenden Strom misst, um daraus einen Isolationswiderstand abzuleiten, oder
- die Messung eine elektrische Durchgangsmessung ist, die beiden Steckverbinder zwei Phasenverbinder (30b, 30c, 30d) sind und das Messgerät ein Amperemeter ist, das einen Strom misst, der zwischen den beiden Phasenverbindern (30b, 30c, 30d) fließt, oder
- die Messung eine Kabelsuche ist, das Messgerät so konfiguriert ist, dass es in die Verbinder (30) mindestens ein Messsignal mit einem bestimmten Muster einspeist, und ein Detektor verwendet wird, um Kabel der Last zu identifizieren, in denen das Messsignal fließt.

11. Verfahren eines Wartungsvorgangs an einem Gerät, das mit den nachgeschalteten Anschlussklemmen (16) einer Schublade nach einem der Ansprüche 1 bis 9 verbunden ist, wenn der Schublade in einen Steckplatz einer elektrischen Schalttafel eingesetzt ist, wobei das Verfahren die folgenden Schritte umfasst:
- Positionierung des Wählers (20) in der Kurzschlussposition,
- Anschließen eines Messgeräts an mindestens zwei Steckverbinder (30) an der Vorderfront (14) der Schublade,
- Überprüfung, ob keine Spannung anliegt,
- Durchführung der Wartungsarbeiten am Gerät.

12. Verfahren nach einem der Ansprüche 10 oder 11, umfassend einen Schritt zum Verriegeln der Positionierung des Wählers (20) unter Verwendung eines Verriegelungsorgans (40) für die Drehung des Griffs (24), der mechanisch mit dem Wähler (20) verbunden ist.

## Claims

1. A drawer comprising:
- a chassis (10) adapted to enable insertion of the drawer in a location of a distribution switchboard,
- a front panel (14) closing the location of the distribution switchboard when the drawer is inserted into a distribution switchboard,
- downstream connection terminals (16) for connection to a load,
- a plurality of connectors (30) opening onto its front panel (14), each of these connectors being connected to a downstream connection terminal (16) and enabling connection of a measurement device,
wherein the drawer has a selector (20), the selector (20) being actuatable from the front panel (14),
**characterised in that** the selector enables the downstream connection terminals (16) to be connected to and disconnected from an equipotential bonding and defines a measurement position wherein the downstream connection terminals (16) are not connected to an equipotential bonding and a short-circuit position wherein the downstream connection terminals (16) are connected to the equipotential bonding.

2. The drawer according to claim 1, wherein the drawer has no upstream connection terminals for connection to a power supply of the electrical distribution board.

3. The drawer according to claim 2, having an insulating interface (18) for facing the power bars of the electrical distribution board.

4. The drawer according to any of the preceding claims, wherein the selector (20) is rotatable between a measurement position in which the downstream connection terminals (16) are not connected to an equipotential bonding and a short-circuit position in which the downstream connection terminals (16) are connected to the equipotential bonding.

5. The drawer according to the preceding claim, further comprising a handle (24) on the front panel (14), said handle being movable between a first position and a second position, the second position causing the drawer to be blocked in the distribution switchboard when the drawer is inserted into the distribution switchboard whereas in the first position the drawer is free from blocking in the distribution switchboard in order to enable its insertion or removal, the handle (24) being mechanically connected to the selector so that rotation of the handle (24) between the first position and the second position causes rotation of the selector (20) between the measurement position and the short circuit position, respectively.

6. The drawer according to the preceding claim, wherein the handle (24) is provided with a member (40) for locking rotation of said handle (24) configured to authorise or prohibit rotation of the handle (24).

7. The drawer according to any of claims 1 to 6, wherein the handle (24) and the selector (20) are rotatable about two distinct axes, and the handle (24) is mechanically connected to the selector (20) by at least one connecting rod (28).

8. The drawer according to any of claims 1 to 6, wherein the drawer comprises an electrically conductive short-circuiting member (22) connectable to an equipotential bonding, and the selector (20) comprises contact members (36) connected to each downstream connection terminal (16) and configured to contact the short-circuiting member (22) by rotating the selector (20).

9. The drawer according to any of the preceding claims, wherein the panel (14) comprises a main part (14a) mechanically connected to the chassis (10), and an extension (14b) fastened to a panel side of the main part (14a).

10. A method for measuring electrical characteristics of a load connected to the downstream connection terminals (16) of a drawer according to any of claims 1 to 9, when said drawer is inserted into a location of an electrical distribution board, said method comprising the following steps of:
- positioning the selector (20) in a measurement position,
- connecting a measurement device to at least two connectors (30) of the front panel (14) of the drawer,
- performing measurements of electrical characteristics of the load,
wherein the downstream connection terminals (16) comprise phase terminals (16b, 16c, 16d) and a ground terminal (16a), a phase connector (30b, 30c, 30d) being connected to a phase terminal (16b, 16c, 16d) and a ground connector (30a) being connected to the ground terminal (16a):
- the measurement is a check for the absence of voltage, and the measurement device is a voltmeter, or
- the measurement is an insulation resistance measurement, the two connectors are a phase connector (30b, 30c, 30d) and a ground connector (30a), and the measuring apparatus is an insulation tester configured to apply a voltage across both connectors and to measure current flowing between both connectors to deduce an insulation resistance therefrom, or
- the measurement is an electrical continuity measurement, both connectors are two phase connectors (30b, 30c, 30d), and the measurement device is an ammeter measuring current flowing between the two-phase connectors (30b, 30c, 30d), or
- the measurement is a cable search, the measuring apparatus is configured to inject at least one measurement signal having a particular pattern into the connectors (30), and a detector is used to identify cables of the load in which said measurement signal is passing.

11. A method of a maintenance operation of equipment connected to the downstream connection terminals (16) of a drawer according to any of claims 1 to 9 when said drawer is inserted into a location of an electrical distribution board, said method comprising the following steps of:
- positioning the selector (20) in a short-circuit position,
- connecting a measurement device to at least two connectors (30) of the front panel (14) of the drawer,
- checking for the absence of voltage,
- performing the maintenance operation on the equipment.

12. The method according to any of claims 10 or 11, comprising a step of locking the positioning of the selector (20) using a member (40) for locking rotation of the handle (24) mechanically connected to the selector (20).
